# EUROPEAN PATENT APPLICATION

(11) **EP 4 621 552 A1**
(43) Date of publication of application: **24.09.2025**
(21) Application number: 25162072.0
(22) Date of filing: 06.03.2025
(51) Int. Cl.: G06F 7/483, H03M 7/24, H03M 7/30

(54) **LOSSLESS HARDWARE COMPRESSION FOR DEEP NEURAL NETWORKS**

(30) Priority: 18.03.2024 US 202418608146
(71) Applicant: Google LLC, Mountain View, CA 94043 (US)
(72) Inventor: SUBRAMANIAN, Suvinay, Mountain View, California, 94043 (US); MAROLIA, Pratik M., Mountain View, California, 94043 (US)
(74) Representative: Betten & Resch

(57) **Abstract**

Systems and methods for compression and decompression of floating point numbers. A floating point number is compressed by accessing a dictionary that associates exponent values with respective exponent indices to determine whether or not the exponent value for the floating point number is present in the dictionary; when the exponent value is present in the dictionary, generating a compressed floating point number for the floating point number by substituting for the exponent value the exponent index corresponding to the exponent value; and when the exponent value is not present in the dictionary, generating a compressed floating point number for the floating point number by substituting for the exponent value an unencoded indicator indicating that the exponent value is located apart from the compressed floating point number.

## Description

### BACKGROUND

A key consideration in computing systems is getting data to and from processors. In particular, memory capacity (e.g., processor on-chip memory), memory bandwidth (e.g., the rate at which data can be read from an in-package memory to a processor on-chip memory), and communication bandwidth (e.g., the rate at which data can be read from a memory external to a package to an in-package memory) are increasingly key to enabling good performance on key production and state-of-the-art deep neural network (DNN) models.

On the application front, Large Language Models (LLMs) are highly memory-bound on accelerators like Tensor Processing Units (TPUs) and Graphics Processing Units (GPUs). For instance, LLM inference is adversely affected when there are too few accelerator chips available to hold LLM model parameters and/or when there is not enough bandwidth to move data from in-package memory to on-chip memory. As these models get larger, more chips are required to train and serve them, making communication bandwidth critical to performance. Traditional DNN models are also subject to the same trends as they get larger. On the systems front, memory capacity and bandwidth, as well as communication bandwidth are difficult to scale in a commensurate manner. While it is generally possible to increase an accelerator's floating point operations per second (FLOPS), the memory and communication wall is a harder challenge.

One way to address the capacity and bandwidth issues is through quantization. Another way to address the capacity and bandwidth issues is through the application of a sparsity technique. Both quantization and sparsity can reduce the number of bits required for the representation of a given data set, thereby reducing the amount of memory required for storage of the data set and the amount of bandwidth needed to transmit the data set. However, both quantization and sparsity are not DNN model-transparent. That is, they require changes to a DNN model for which they are employed and may impact the model's quality. Furthermore, the implementation of quantization and/or sparsity techniques is inconsistent amongst those employing the techniques.

Still another way to address the capacity and bandwidth issues is through data compression. By compressing the data, the data requires less memory space for storage and less bandwidth for transmission, thereby increasing the effective memory capacity and the effective bandwidth. A variety of compression techniques have been employed - both lossy and lossless. However, lossy formats can degrade the quality of a DNN model for which they are employed, which is often unappealing to end users of the model; and lossless formats have been limited to simple techniques like run-length encoding (RLE).

### BRIEF SUMMARY

In view of the drawbacks associated with prior techniques for getting data to and from computer system processors, the presently disclosed technology was conceived and developed. The technology provides for robust and efficient handling of data, particularly in the context of DNNs, through a lossless hardware compression (LHC) solution for floating-point tensors. The technology may be used to improve effective memory capacity, memory bandwidth, and/or communication bandwidth of a DNN accelerator. Additionally, the present technology may support a range of floating point (fp) arithmetic in the memory data path transparently, that is, without impacting model quality and without necessitating purpose-built hardware for each individual fp decomposition. Using the technology, compressed data may be decompressed along the load datapath of a processor, transparent to the processor software, thereby avoiding the reduction in performance that would result from the processor software operations and on-chip memory bandwidth consumption required for processor decompression.

In one aspect, the presently disclosed technology provides a method for compressing floating point numbers including, for each of multiple floating point numbers that each include an exponent value, accessing a dictionary that associates exponent values with respective exponent indices to determine whether or not the exponent value for the floating point number is present in the dictionary; when the exponent value is present in the dictionary, generating a compressed floating point number for the floating point number by substituting the exponent index corresponding to the exponent value for the exponent value; and when the exponent value is not present in the dictionary, generating a compressed floating point number for the floating point number by substituting an unencoded indicator for the exponent value, the unencoded indicator indicating that the exponent value is located apart from the compressed floating point number.

In another aspect, the presently disclosed technology provides a method for decompressing compressed floating point numbers including, for each of multiple compressed floating point numbers that has been generated from a respective floating point number by substituting one of an exponent index or an unencoded indicator for an exponent value of the floating point number, when the compressed floating point number includes an exponent index, accessing a dictionary that associates exponent values with respective exponent indices to cross-reference the exponent index to the exponent value of the floating point number, and generating the floating point number from the compressed floating point number by substituting the exponent value of the floating point number for the exponent index; and when the compressed floating point number includes an unencoded indicator, fetching the exponent value of the floating point number, and generating the floating point number from the compressed floating point number by substituting the exponent value of the floating point number for the unencoded indicator.

In still another aspect, the presently disclosed technology provides a processing system including a processing chip having a processor and a direct memory access (DMA) and decompression engine; and an external memory, wherein the DMA and decompression engine is operable to receive multiple compressed floating point numbers and implement decompression of the compressed floating point numbers by, for each of the compressed floating point numbers that has been generated from a respective floating point number by substituting one of an exponent index or an unencoded indicator for an exponent value of the floating point number, when the compressed floating point number includes an exponent index, accessing a dictionary that associates exponent values with respective exponent indices to cross-reference the exponent index to the exponent value of the floating point number, and generating the floating point number from the compressed floating point number by substituting the exponent value of the floating point number for the exponent index; and when the compressed floating point number includes an unencoded indicator, fetching the exponent value of the floating point number, and generating the floating point number from the compressed floating point number by substituting the exponent value of the floating point number for the unencoded indicator.

### BRIEF DESCRIPTION OF THE DRAWINGS

The accompanying drawings are not intended to be drawn to scale. Also, for purposes of clarity not every component may be labeled in every drawing. In the drawings:
Fig. 1 is a block diagram of a processing system according to an embodiment.
Fig. 2 is a block diagram of a computing resource that may be used as the processing chip of Fig. 1.
Fig. 3 is a sequence diagram depicting the compression of a tensor having n floating point numbers.
Fig. 4 is a diagram contrasting the compressed tensor of Fig. 3 with an alternate format version of the compressed tensor of Fig. 3.
Fig. 5 is a diagram showing another alternate format of compressed tensor.
Fig. 6 is a sequence diagram depicting decompression of a fixed sized block of a compressed tensor.
Fig. 7 is a sequence diagram depicting how a desired portion of an uncompressed tensor may be retrieved from a corresponding compressed tensor without decompressing the entire compressed tensor.

### DETAILED DESCRIPTION

Examples of systems and methods are described herein. It should be understood that the words "example," "exemplary" and "illustrative" are used herein to mean "serving as an example, instance, or illustration." Any embodiment or feature described herein as being an "example," "exemplary" or "illustration" is not necessarily to be construed as preferred or advantageous over other embodiments or features. In the following description, reference is made to the accompanying figures, which form a part thereof. In the figures, similar symbols typically identify similar components, unless context dictates otherwise. Other embodiments may be utilized, and other changes may be made, without departing from the spirit or scope of the subject matter presented herein.

The example embodiments described herein are not meant to be limiting. It will be readily understood that the aspects of the present disclosure, as generally described herein, and illustrated in the figures, can be arranged, substituted, combined, separated, and designed in a wide variety of different configurations, all of which are explicitly contemplated herein.

### Overview

The presently disclosed lossless hardware compression (LHC) solution for floating-point tensors in deep neural networks embodies the following advancements.
- **Empirical observation on compressibility of exponent-bits:** Floating-point numbers are decomposed as (sign, exponent, mantissa) bits. The number of bits for each depends on the specific floating-point format - e.g., fp32 := (1, 8, 23), fp16 := (1, 5, 10), bf16 := (1 ,8, 7), fp8 := (1, 4, 3) / (1, 3, 4), etc. Regardless of the specific format, exponent bits often exhibit lower entropy and are amenable to compression.
- **Transparent compression and online hardware decompression of floating-point tensors:** A compression representation that leverages the realization that exponent bits often exhibit lower entropy and are amenable to compression so as to transparently compress (encode) exponent bits; and a design of associated hardware to decode the compressed exponent bits in such compression representation, online and close to the computation engines in a DNN accelerator.
- **Metadata schema to enable tiling and indexed-access into compressed tensors:** A design of a metadata schema that enables accessing specific regions of the compressed tensor, which is critical for performant execution of DNN operations, and a key requirement for any high-performance compiler for DNN accelerators.
- **Flexible support of multiple floating-point formats:** A solution that supports a variety of floating-point decompositions in the memory data path. This is important because (a) there has been no prior consensus on the best decomposition for floating-point formats (especially lower-bit formats) vis-a-vis impact on model quality, and (b) it is difficult to purpose-build hardware for each specific decomposition (e.g., different compute engines for e4m3 vs. e3m4). Also, DNN accelerator hardware is often designed multiple years before deployment with limited visibility into future developments. The present solution provides the requisite flexibility without indexing on a specific floating-point format in advance.
- **Model transparent compression:** A solution that is model transparent from a user-perspective - a user can train a model in a high-resolution floating point (fp) format (e.g., bf16) and transparently deploy the same model while reaping the benefits of fewer-bits floating-point representation. This is important because: (a) different models (and even different tensors within a model) are amenable to different degrees of compression, and (b) determining the appropriate low-bit fp representation can often involve significant user effort - ranging from quantization-aware training to auto machine learning (ML) to determine the right mixed-precision formats for different layers and operators, and studying the impact on model quality. The present solution incurs no model quality implications (what-you-train-is-what-you-serve WYTIWYS) and expedites model deployment.
- **Quality-commensurate performance gains:** The present solution transparently provides mixed-precision on-the-fly for different layers/tensors in a model (or even sub-regions of tensors), while reaping the benefits of a lower number of bits (i.e., improved effective memory capacity and bandwidth). The solution is reliant only on the underlying compressibility of the exponents in the tensor. The actual computations are performed in the original (user-intended/trained) floating-point format.

### Illustrative Embodiments

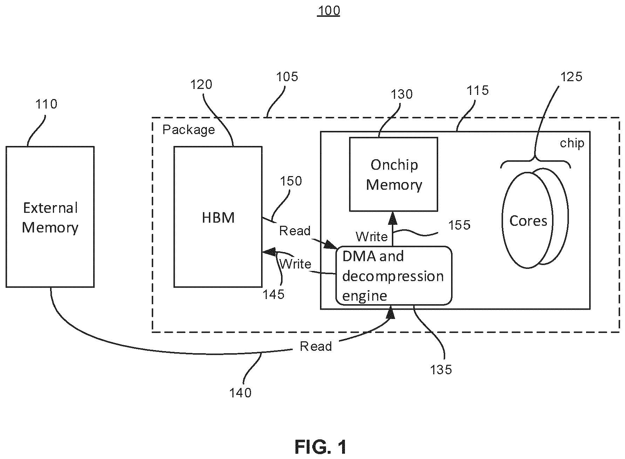

Fig. 1 is a block diagram of a processing system 100 according to an embodiment. The processing system 100 may be, for example, a system for training and implementing an ML algorithm such as an LLM. As can be seen from Fig. 1, the processing system 100 may include a package 105 and an external memory 110, and the package 105 may include a processing chip 115 and a high bandwidth memory (HBM) 120. Further, the processing chip 115 may include one or more processing cores 125, an on-chip memory 130, and a direct memory access (DMA) and decompression engine 135. The DMA and decompression engine 135 may be a dedicated hardware block, and the processing cores 125 may call the DMA and decompression engine 135 to move data between memories. The processing system 100 may employ one or more of the compression algorithms and/or decompression algorithms of the presently disclosed technology.

In one possible application, the processing system 100 executes an ML algorithm using compressed tensor weights stored in the external memory 110. In such application, the tensor weights may be compressed prior to execution of the algorithm - either by the processing system 100 or by another processing system - and stored in the external memory 110. The tensor weights may then be read from the external memory 110 by the DMA and decompression engine 135 of the package 105, as illustrated by flow 140, and applied to input data when the processing system 100 is executing the ML algorithm. In this manner, the communication bandwidth required to execute the ML algorithm is reduced. That is, by communicating compressed weights from the external memory 110 to the package 105 rather than communicating uncompressed weights from the external memory 110 to the package 105, the communication bandwidth required to communicate the weights from the external memory 110 to the package 105 is reduced.

After the tensor weights have been read from the external memory 110 by the DMA and decompression engine 135, the DMA and decompression engine 135 may decompress the weights and transmit the decompressed weights to the HBM 120 for storage, as illustrated by flow 145. The decompressed weights may then be retrieved from HBM 120 as needed by the processing chip 115, through DMA and decompression engine 135, as illustrated by flow 150. In this regard, the link between the HBM 120 and the processing chip 115 is typically characterized by a memory bandwidth that is larger than the communication bandwidth between the external memory 110 and the processing chip 115, thereby allowing for communication of the uncompressed weights between the HBM 120 and the processing chip 115 without adverse effects on system performance. Also, the decompressed weights retrieved from HBM 120 by DMA and decompression engine 135 may be sent from the DMA and decompression engine 135 to the on-chip memory 130 for access by the processing cores 125, as illustrated by flow 155.

It should be noted that the processing system 100 is merely one example of a system that may employ one or more of the compression algorithms and/or decompression algorithms of the present disclosure. Upon review of this disclosure, one skilled in the art will readily appreciate the wide range of systems that may employ the presently disclosed compression algorithms and/or decompression algorithms. For one, if the memory bandwidth between the HBM 120 and the processing chip 115 presents a bottleneck, the DMA and decompression engine 135 may store in HBM 120 the compressed weights it receives from the external memory 110 rather than decompress the compressed weights prior to storage in HBM 120; after which the compressed weights can be read from the HBM 120 and decompressed by DMA and decompression engine 135 and sent to the on-chip memory 130. In this manner, by communicating compressed weights from the HBM 120 to the package processing chip 115 rather than communicating uncompressed weights from the HBM 120 to the processing chip 115, the memory bandwidth required to communicate the weights from the HBM 120 to the processing chip 115 is reduced and the bottleneck avoided.

In another embodiment, an ML algorithm is executed by a processing system like processing system 100 but without the external memory 110 and without flow 140. In such embodiment, weights may be generated by the processing cores 125, and then compressed and stored in the HBM 120. When the weights are needed, they can be read from the HBM 120 by DMA and decompression engine 135 as illustrated by flow 150, decompressed, and communicated to on-chip memory 130 as illustrated by flow 155.

In still another alternative embodiment, an ML algorithm is executed by a processing system like processing system 100 but without the HBM 120 and without flows 145 and 150. In such alternative embodiment, compressed weights stored in external memory 110 can be read by DMA and decompression engine 135, decompressed, and communicated directly to on-chip memory 130 as illustrated by flow 155.

It should be further noted that the present technology is not limited to compression and decompression of ML weights. For instance, the technology may be used for compression and decompression of ML gradients or ML activation data, or may be used for compression and decompression of data in applications other than ML applications.

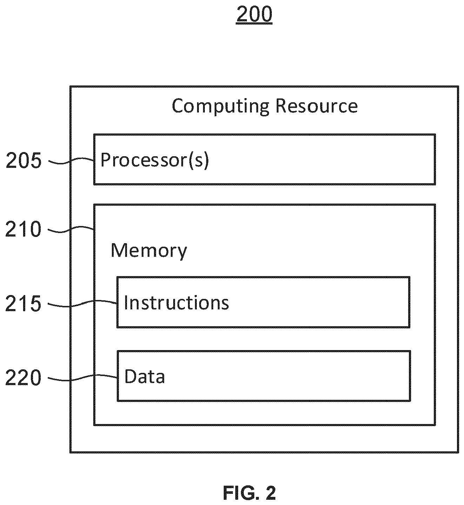

Turning now to Fig. 2, the figure is a block diagram of a computing resource 200 that may be used as the processing chip 115 of Fig. 1. The computing resource 200 may include one or more processors 205 and a memory 210 storing instructions 215 and data 220. When the computing resource 200 is used as the processing chip 115 of Fig. 1, the processors 205 may serve as processing cores 125, the memory 210 may serve as on-chip memory 130, and the instructions 215 and/or data 220 may cause the system 100 to execute an ML algorithm. Moreover, the computing resource 200 may be resident on a single computing device. For example, the computing resource 200 may be a server, personal computer, or mobile device, and thus an ML algorithm implemented by the computing resource 200 may be local to a single computing device. Alternatively, the computing resource 200 may be resident on a cloud computing system or other distributed system. In such a case, an ML algorithm implemented by the computing resource 200 may be distributed across two or more different physical computing devices.

In addition, it is noted that the computing resource 200 may be used to implement the DMA and decompression engine 135 according to some embodiments. In other embodiments, the DMA and decompression engine 135 may take the form of an application-specific integrated circuit (ASIC), a field programmable gate array (FPGA), or the like.

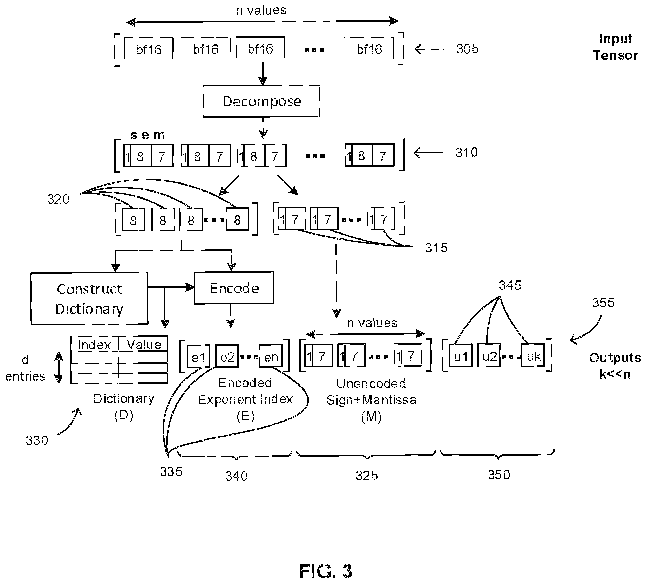

Fig. 3 is a sequence diagram depicting the compression of a tensor 305 having n floating point numbers, n being an integer. In one application, the compression performed in Fig. 3 is performed on a weight tensor and the resulting compressed tensor is stored in the external memory 110 of Fig. 1 for use by an ML algorithm. In any event, as can be seen from Fig. 3, the tensor 305 includes, by way of example, floating point numbers of bf16 format, with each floating point number including a sign value represented by one bit, an exponent value represented by eight bits, and a mantissa value represented by seven bits (see reference 310). The sign and mantissa values are separated from their respective exponent values to form n sign+mantissa values 315 and n exponent values 320. The sign+mantissa values 315 are formed into a continuous sign+mantissa chain 325. The exponent values 320 are used to construct a dictionary 330 and are then encoded using the dictionary 330.

The dictionary 330 associates exponent values with respective exponent indices as a way to encode the exponent values so that the exponent values may be represented using fewer bits. One way to form dictionary 330 is to determine from among the exponent values 320 the top d most frequently occurring ones of the exponent values 320, d being an integer greater than or equal to 1, and then assign an exponent index to each of the top d most frequently occurring ones of the exponent values 320 and assign an unencoded indicator to all other ones of the exponent values 320. Another way to form the dictionary 330 is to determine from among the exponent values 320 the first d unique ones of the exponent values 320, d being an integer greater than or equal to 1, and then assign an exponent index to each of the first d unique ones of the exponent values 320 and assign an unencoded indicator to all other ones of the exponent values 320. Once the dictionary 330 is formed, it may be used to encode the exponent values 320.

To encode the exponent values 320, for each of the exponent values 320 the dictionary 330 is accessed to determine whether or not the exponent value is assigned an exponent index or the unencoded indicator. When the exponent value is assigned an exponent index, the exponent index corresponding to the exponent value is substituted for the exponent value. When the exponent value is assigned the unencoded indicator, the unencoded indicator is substituted for the exponent value and the exponent value is included in the compressed tensor in unencoded form. The exponent indices and unencoded indicators thus generated, denote encoded exponents 335, and are grouped into a continuous encoded exponent chain 340. Further, any of the exponent values 320 that were found to correspond to the unencoded indicator denote unencoded exponents 345, and are grouped into a continuous unencoded exponent chain 350.

To form a compressed tensor 355 corresponding to tensor 305, the dictionary 330, the encoded exponent chain 340, the sign+mantissa chain 325, and the unencoded exponent chain 350 are concatenated.

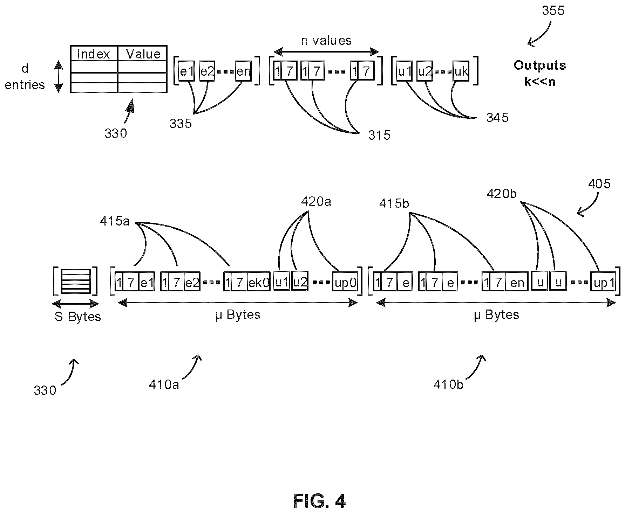

Fig. 4 is a diagram contrasting the compressed tensor 355 of Fig. 3 with an alternate format version of the compressed tensor 355. The alternate format version is denoted as compressed tensor 405. Both compressed tensor 355 and compressed tensor 405 result from compression of uncompressed tensor 305. In the compressed tensor 405, the sign+mantissa values 315, the encoded exponents 335, and the unencoded exponents 345 are partitioned into fixed size blocks, denoted as micro-blocks. More specifically, the compressed tensor 405 includes the dictionary 330, a first micro-block 410a of size µ bytes, and a second micro-block 410b of size µ bytes. As can be seen from Fig. 4, micro-block 410a includes compressed floating point entries 415a and unencoded exponent entries 420a. The compressed floating point entries 415a respectively correspond to the first k0 of the n floating point numbers and each compressed floating point entry 415a comprises the sign+mantissa value 315 and the encoded exponent 335 for the corresponding floating point number. The unencoded exponent entries 420a are the unencoded exponents 345 for the compressed floating point entries 415a, numbered to p0 by way of illustration - indicating that p0 of the compressed floating point entries 415a include an unencoded indicator rather than an exponent index. Micro-block 410b includes n-k0 floating point entries 415b and unencoded exponent entries 420b. The floating point entries 415b respectively correspond to the next k0+1 to n of the n floating point numbers and each comprise the sign+mantissa value 315 and the encoded exponent value 335 for the corresponding floating point number. The unencoded exponent entries 420b are the unencoded exponents 345 for the floating point entries 415b, numbered to p1 by way of illustration - indicating that p1 of the compressed floating point entries 415b include an unencoded indicator rather than an exponent index.

The fixed size micro-blocks of Fig. 4 may correspond to variable sized uncompressed data. That is, the amount of uncompressed data represented by micro-block 410a may differ from the amount of uncompressed data represented by micro-block 410b. Further, the amount of uncompressed data for each of micro-blocks 410a and 410b may be an integer multiple of an uncompressed unit size, regardless of whether or not the micro-blocks 410a and 410b are the same size. By way of example, each of micro-blocks 410a and 410b may be 512 bytes in size and correspond to different amounts of uncompressed data, while the amount of uncompressed data represented by each block is a multiple of 32 bytes.

The use of fixed size compressed blocks aligning with an uncompressed unit size possesses advantages. For one, such use provides for optimal memory paging. Further, in some embodiments, the fixed size compressed blocks may be sized to match a pseudo-channel (PC) access granularity, so that each compressed block can be decompressed in its entirety without requiring the fetching of data from multiple pseudo-channels. Also, aligning each compressed block with an uncompressed unit size facilitates tiled access into the compressed data.

In some embodiments, micro-blocks each contain the same number of decompressed elements and are padded so that the micro-blocks contain the same number of bytes. Including the same number of decompressed elements in each micro-block allows for stride counting. That is, for example, if a user wants to access the 10th element of an uncompressed tensor, and knows that each micro-block represents 4 uncompressed elements, then the user can readily ascertain that the 10th element can be found in the 3rd micro-block. Padding the micro-blocks to contain the same number of bytes enhances performance by matching the width of the micro-blocks to the memory width, such that the micro-blocks can be stored in memory without wasting memory bandwidth.

In any event, it should be noted that Fig. 4 depicts two micro-blocks for purposes of illustration only. The number of micro-blocks in a compressed tensor may be 1 micro-block or more than two-micro-blocks.

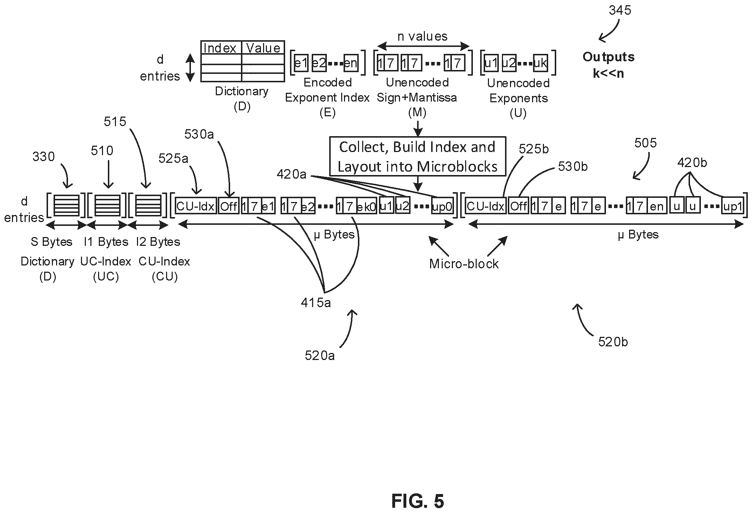

Referring now to Fig. 5, the figure is a diagram showing an alternate format compressed tensor 505. The compressed tensor 505 includes the dictionary 330, a tensor uncompressed-compressed index 510, a tensor compressed-uncompressed index 515, and two micro-blocks 520a and 520b. While two micro-blocks are shown in Fig. 5, it should be understood that two micro-blocks are shown only for purposes of illustration and that the compressed tensor 505 may include one micro-block or more than two micro-blocks.

The micro-blocks 520a and 520b of Fig. 5 have the same form as micro-blocks 410a and 410b of Fig. 4, with the exception that each of micro-blocks 520a and 520b include a block compressed-uncompressed index, respectively block compressed-uncompressed indexes 525a and 525b, and an unencoded exponent offset, respectively unencoded exponent offsets 530a and 530b. The block compressed-uncompressed index 525a indicates the offset within the uncompressed tensor of the uncompressed floating point numbers represented by micro-block 520a. For example, the compressed-uncompressed-index 525a is an integer that is multiplied by an uncompressed unit size to indicate the offset within the uncompressed tensor of the uncompressed floating point numbers represented by micro-block 520a. Similarly, the block compressed-uncompressed index 525b indicates the offset within the uncompressed tensor of the uncompressed floating point numbers represented by micro-block 520b. The presence of the block compressed-uncompressed indexes 525a and 525b facilitate decompression of compressed tensor 505 by allowing the positions of the uncompressed floating point numbers of each micro-block to be readily determined. The unencoded exponent offset 530a indicates the position within micro-block 520a where the unencoded exponent entries 420a are located. Similarly, the unencoded exponent offset 530b indicates the position within micro-block 520b where the unencoded exponent entries 420b are located.

Regarding the tensor uncompressed-compressed index 510, it associates portions of the corresponding uncompressed tensor with respective positions within the compressed tensor 505. So, for example, if the presently disclosed technology is used to compress tensor 305 of Fig. 3 and yields compressed tensor 505, the uncompressed-compressed index 510 associates portions of tensor 305 with respective positions within compressed tensor 505. Thus, the uncompressed-compressed index 510 enables tiling (windowing). That is, if the uncompressed-compressed index 510 is a table cross-referencing uncompressed tiles of tensor 305, identified by an uncompressed tile index, to positions within the compressed tensor 505, then when given an uncompressed tile index, the uncompressed-compressed index 510 may be used to locate the tile's corresponding location within the compressed tensor 505. In some embodiments, the uncompressed-compressed index 510 is a table that maps an index u, where u represents the u-th uncompressed tile of Δ-Bytes, to a location indicator, the location indicator capturing both the micro-block of tensor 505 in which the tile is located and an offset within the decompressed micro-block where the tile is located. For example, Δ-Bytes may be 512 bytes, and the offset within the decompressed micro-block where the tile is located may be expressed as a multiple of an uncompressed unit size such as 32 bytes.

Regarding the tensor compressed-uncompressed index 515, it associates, for each of the micro-blocks, the respective positions within the uncompressed tensor of the floating point numbers corresponding to the micro-blocks. So, for example, if the presently disclosed technology is used to compress tensor 305 of Fig. 3 and yields compressed tensor 505, the compressed-uncompressed index 515 associates micro-blocks 520a and 520b with respective positions within tensor 305 of the floating point numbers corresponding to the micro-blocks 520a and 520b. Thus, the tensor compressed-uncompressed index 515 performs a function similar to that of the block compressed-uncompressed indexes 525a and 525b, but the tensor compressed-uncompressed index 515 is outside of the micro-blocks 520a and 520b and includes information for multiple micro-blocks, i.e., for both of the micro-blocks 520a and 520b, rather than information for just one micro-block. By way of example, the tensor compressed-uncompressed index 515 may be a table that maps an index c, where c is an integer representing the c-th micro-block in a compressed tensor, to an offset in a corresponding uncompressed tensor, with the offset being expressed as integer multiple of an uncompressed unit size, such that the position of the in the uncompressed tensor is determined by multiplying the offset by the uncompressed unit size. Further, it should be noted that embodiments are not limited to a tensor compressed-uncompressed index having information for two micro-blocks, and the tensor compressed-uncompressed index 515 may include information for all micro-blocks of a compressed tensor regardless of the number of micro-blocks in the compressed tensor. In any event, provision of the compressed-uncompressed index 515 allows for efficient identification of the uncompressed data corresponding to a given portion of compressed data.6

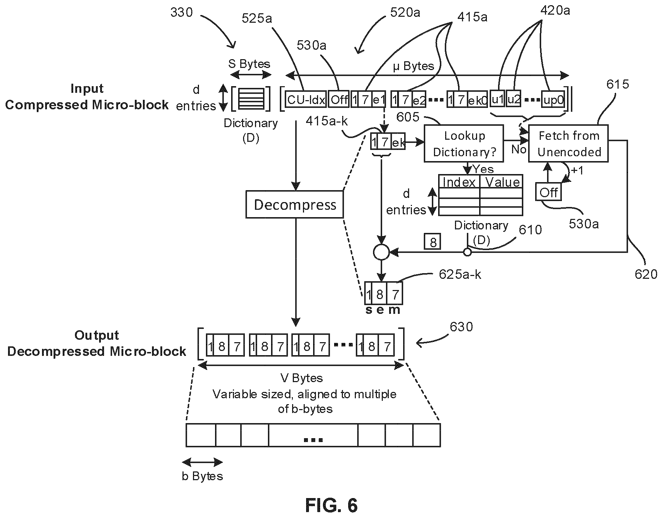

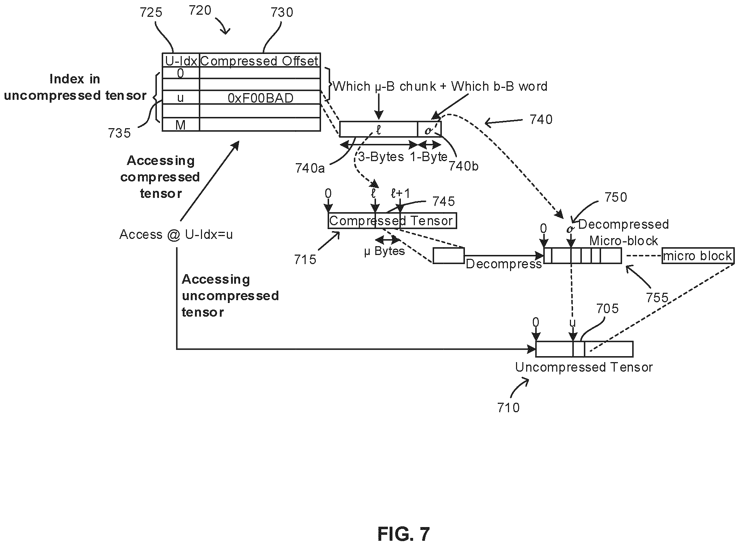

Turning now to Figs. 6 and 7, illustrative decompression will be described with reference to the compressed tensor 505 of Fig. 5.

Fig. 6 is a sequence diagram depicting decompression of micro-block 520a of Fig. 5. As can be seen from Fig. 6, decompression of micro-block 520a may proceed by sequentially decompressing each of the compressed floating point entries 415a, with the compressed floating point entry that is currently being decompressed indicated as compressed floating point entry 415a-k. When compressed floating point entry 415a-k is being decompressed, one of two functions is performed dependent on whether or not the encoded exponent is an exponent index that is present in the dictionary 330 or the encoded exponent is an unencoded indicator indicating that the corresponding exponent value is included as an unencoded exponent entry 420a. In the first case, the encoded exponent of floating point entry 415a-k is looked up in the dictionary 330 to determine the corresponding exponent value (function 605) and the exponent value is retrieved (path 610). In the second case, the exponent value is located in the unencoded exponent entries 420a (function 615) and retrieved therefrom (path 620). Further, in the case of retrieving exponent values from the unencoded exponent entries 420a, the position of the exponent value is determined by adding the unencoded exponent offset 530a to a counter value, with the counter value being incremented each time an exponent value is fetched from the unencoded exponent entries 420a.

Once the exponent value for compressed floating point entry 415a-k has been retrieved it is combined with the sign value and mantissa value of compressed floating point entry 415a-k to yield a floating point number 625a-k corresponding to compressed floating point entry 415a-k. Further, once each of the compressed floating point entries 415a has undergone the decompression as described with reference 415a-k, the resulting sequence of floating point numbers is a decompressed micro-block 630 corresponding to micro-block 520a.

As shown in Fig. 6, the size of the decompressed micro-block 630 may be an integer multiple of an uncompressed unit size (e.g., b-bytes); and the position of the decompressed micro-block 630, within the corresponding uncompressed tensor may be indicated by the block compressed-uncompressed index 525a. The entirety of the uncompressed tensor corresponding to compressed tensor 505 may be generated by decompressing both of micro-blocks 520a and 520b in the manner illustrated in Fig. 6.

Referring now to Fig. 7, the figure is a sequence diagram depicting how a desired portion 705 of an uncompressed tensor 710 may be retrieved from a corresponding compressed tensor 715 without decompressing the entire compressed tensor 715. As can be seen from Fig. 7, a tensor uncompressed-compressed index 720, like the tensor uncompressed-compressed index 510 of Fig. 5, may be referenced to determine the position within the compressed tensor 715 corresponding to the desired portion 705 of the uncompressed tensor 710. For instance, the tensor uncompressed-compressed index 720 associates uncompressed tensor indexes 725 with respective compressed tensor offsets 730, and each compressed tensor offset 730 identifies a micro-block of the compressed tensor 715 corresponding to the associated tensor index 725. In addition, each compressed tensor offset indicates an offset within the decompressed data of the identified micro-block of the compressed floating point numbers corresponding to the uncompressed tensor index 725. Thus, for example, if the desired portion 705 of the uncompressed tensor 710 is designated by a uncompressed tensor index u 735 (e.g., the u-th tile of uncompressed tensor 710), then the tensor uncompressed-compressed index 720 is referenced to determine that compressed tensor offset 740 corresponds to the uncompressed tensor index u 735; with the compressed tensor offset 740 including a first portion 740a indicative of a micro-block 745 corresponding to the compressed tensor index u 735 and a second portion 740b indicative of an offset 750 within the decompressed data 755 of micro-block 745. The offset 750 indicates the position within decompressed data 755 of the floating point numbers corresponding to the desired portion 705. Thereby, given an uncompressed-compressed index value for a desired portion of an uncompressed tensor, one may readily determine which micro-block of the corresponding compressed tensor must be decoded to retrieve the desired portion and the position within the decompressed micro-block of the desired portion.

In some embodiments, the tensor uncompressed-compressed index 720 is a table that maps an index u, where u represents the u-th uncompressed tile of Δ-Bytes, to the micro-block corresponding to the tile and to an offset within the decompressed micro-block where the floating point numbers of the tile are located. For example, Δ-Bytes may be 512 bytes, and the offset within the decoded micro-block where the tile is located may be expressed as an integer multiple of an uncompressed unit size such as 32 bytes.

Embodiments of the present technology include, but are not restricted to, the following.
(1) A method for compressing floating point numbers including, for each of multiple floating point numbers that each include an exponent value, accessing a dictionary that associates exponent values with respective exponent indices to determine whether or not the exponent value for the floating point number is present in the dictionary; when the exponent value is present in the dictionary, generating a compressed floating point number for the floating point number by substituting the exponent index corresponding to the exponent value for the exponent value; and when the exponent value is not present in the dictionary, generating a compressed floating point number for the floating point number by substituting an unencoded indicator for the exponent value, the unencoded indicator indicating that the exponent value is located apart from the compressed floating point number.
(2) The method according to (1), further including generating the dictionary.
(3) The method according to (2), wherein generating the dictionary includes determining from among the exponent values for the multiple floating point numbers the top d most frequently occurring exponent values, d being an integer greater than or equal to 1, and assigning the exponent indices to respective ones of the top d most frequently occurring exponent values.
(4) The method according to (2), wherein generating the dictionary includes determining from among the exponent values for the multiple floating point numbers the first d unique exponent values, d being an integer greater than or equal to 1, and assigning the exponent indices to respective ones of the first d unique exponent values.
(5) The method according to (1), further including arranging the compressed floating point numbers into one or more blocks of equal size, each of the blocks corresponding to an amount of uncompressed data that is an integer multiple of an uncompressed unit size, wherein for each block, when the block includes a compressed floating point number having an unencoded indicator, the exponent value corresponding to the compressed floating point number is included in the block.
(6) The method according to (5), wherein the floating point numbers are included in a tensor, and the method further includes generating a compressed tensor having the compressed floating point numbers and the dictionary.
(7) The method according to (6), wherein each block further includes a block compressed-uncompressed index indicating a position within the tensor of the floating point numbers corresponding to the block.
(8) The method according to (6), wherein for each block including at least one unencoded indicator, the block has an unencoded exponent offset indicating a position within the block of the exponent value corresponding to the unencoded indicator.
(9) The method according to (6), wherein the compressed tensor includes a tensor uncompressed-compressed index that associates portions of the tensor with respective positions within the compressed tensor.
(10) The method according to (6), wherein the compressed tensor includes a tensor compressed-uncompressed index that associates, for each of the blocks, the respective position within the tensor of the floating point numbers corresponding to the block.
(11) A method for decompressing compressed floating point numbers including, for each of multiple compressed floating point numbers that has been generated from a respective floating point number by substituting one of an exponent index or an unencoded indicator for an exponent value of the floating point number, when the compressed floating point number includes an exponent index, accessing a dictionary that associates exponent values with respective exponent indices to cross-reference the exponent index to the exponent value of the floating point number, and generating the floating point number from the compressed floating point number by substituting the exponent value of the floating point number for the exponent index; and when the compressed floating point number includes an unencoded indicator, fetching the exponent value of the floating point number, and generating the floating point number from the compressed floating point number by substituting the exponent value of the floating point number for the unencoded indicator.
(12) The method according to (11), wherein when the compressed floating point numbers are arranged into one or more blocks of equal size, each of the blocks corresponding to an amount of uncompressed data that is an integer multiple of an uncompressed unit size, and wherein for each block, when the block includes a compressed floating point number having an unencoded indicator, the exponent value corresponding to the compressed floating point number is included in the block, and fetching the exponent value corresponding to the compressed floating point number includes fetching the exponent value corresponding to the compressed floating point number from within the block.
(13) The method according to (12), wherein the compressed floating point numbers are included in a compressed tensor with the dictionary, and the method includes generating a tensor from the compressed tensor.
(14) The method according to (13), wherein each block further includes a block compressed-uncompressed index indicating a position within the tensor of the floating point numbers corresponding to the block, and generating the tensor further includes referencing the block compressed-uncompressed index.
(15) The method according to (13), wherein for each block including at least one unencoded indicator, the block has an unencoded exponent offset indicating a position within the block of the exponent value corresponding to the unencoded indicator, and the method further includes, for each block including at least one unencoded indicator, referencing the unencoded exponent offset for the block.
(16) The method according to (13), wherein the compressed tensor includes a tensor uncompressed-compressed index that associates portions of the tensor with respective positions within the compressed tensor, and the method further includes referencing the tensor uncompressed-compressed index to identify (i) a block of the compressed tensor corresponding to a designated portion of the tensor, and (ii) a position within uncompressed data of the identified block corresponding to the floating point numbers of the designated portion of the tensor.
(17) The method according to (13), wherein the compressed tensor includes a tensor compressed-uncompressed index that associates, for each of the blocks, the respective position within the tensor of the floating point numbers corresponding to the block, and generating the tensor further includes referencing the tensor compressed-uncompressed index.
(18) A processing system including a processing chip having a processor and a direct memory access (DMA) and decompression engine; and an external memory, wherein the DMA and decompression engine is operable to receive multiple compressed floating point numbers and implement decompression of the compressed floating point numbers by, for each of the compressed floating point numbers that has been generated from a respective floating point number by substituting one of an exponent index or an unencoded indicator for an exponent value of the floating point number, when the compressed floating point number includes an exponent index, accessing a dictionary that associates exponent values with respective exponent indices to cross-reference the exponent index to the exponent value of the floating point number, and generating the floating point number from the compressed floating point number by substituting the exponent value of the floating point number for the exponent index; and when the compressed floating point number includes an unencoded indicator, fetching the exponent value of the floating point number, and generating the floating point number from the compressed floating point number by substituting the exponent value of the floating point number for the unencoded indicator.
(19) The processing system according to (18), wherein when the compressed floating point numbers are arranged into one or more blocks of equal size, each of the blocks corresponding to an amount of uncompressed data that is an integer multiple of an uncompressed unit size, and wherein for each block, when the block includes a compressed floating point number having an unencoded indicator, the exponent value corresponding to the compressed floating point number is included in the block and fetching the exponent value corresponding to the compressed floating point number includes fetching the exponent value corresponding to the compressed floating point number from within the block.
(20) The processing system according to (19), wherein the compressed floating point numbers are included in a compressed tensor with the dictionary, and the method includes generating a tensor from the compressed tensor.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims.

## Claims

1. A method for compressing floating point numbers comprising:
for each of multiple floating point numbers that each include an exponent value
accessing a dictionary that associates exponent values with respective exponent indices to determine whether or not the exponent value for the floating point number is present in the dictionary;
when the exponent value is present in the dictionary, generating a compressed floating point number for the floating point number by substituting the exponent index corresponding to the exponent value for the exponent value; and
when the exponent value is not present in the dictionary, generating a compressed floating point number for the floating point number by substituting an unencoded indicator for the exponent value, the unencoded indicator indicating that the exponent value is located apart from the compressed floating point number.

2. The method according to claim 1, further comprising generating the dictionary.

3. The method according to claim 2, wherein generating the dictionary comprises determining from among the exponent values for the multiple floating point numbers the top d most frequently occurring exponent values, d being an integer greater than or equal to 1, and assigning the exponent indices to respective ones of the top d most frequently occurring exponent values; or
wherein generating the dictionary comprises determining from among the exponent values for the multiple floating point numbers the first d unique exponent values, d being an integer greater than or equal to 1, and assigning the exponent indices to respective ones of the first d unique exponent values.

4. The method according to anyone of the preceding claims, further comprising arranging the compressed floating point numbers into one or more blocks of equal size, each of the blocks corresponding to an amount of uncompressed data that is an integer multiple of an uncompressed unit size,
wherein for each block, when the block includes a compressed floating point number having an unencoded indicator, the exponent value corresponding to the compressed floating point number is included in the block.

5. The method according to claim 4, wherein the floating point numbers are included in a tensor, and the method further comprises generating a compressed tensor comprising the compressed floating point numbers and the dictionary.

6. The method according to claim 5, wherein each block further comprises a block compressed-uncompressed index indicating a position within the tensor of the floating point numbers corresponding to the block; and/or
wherein for each block including at least one unencoded indicator, the block comprises an unencoded exponent offset indicating a position within the block of the exponent value corresponding to the unencoded indicator; and/or
wherein the compressed tensor comprises a tensor uncompressed-compressed index that associates portions of the tensor with respective positions within the compressed tensor; or
wherein the compressed tensor comprises a tensor compressed-uncompressed index that associates, for each of the blocks, the respective position within the tensor of the floating point numbers corresponding to the block.

7. A method for decompressing compressed floating point numbers comprising:
for each of multiple compressed floating point numbers that has been generated from a respective floating point number by substituting one of an exponent index or an unencoded indicator for an exponent value of the floating point number
when the compressed floating point number includes an exponent index, accessing a dictionary that associates exponent values with respective exponent indices to cross-reference the exponent index to the exponent value of the floating point number, and generating the floating point number from the compressed floating point number by substituting the exponent value of the floating point number for the exponent index; and
when the compressed floating point number includes an unencoded indicator, fetching the exponent value of the floating point number, and generating the floating point number from the compressed floating point number by substituting the exponent value of the floating point number for the unencoded indicator.

8. The method according to claim 7, wherein when the compressed floating point numbers are arranged into one or more blocks of equal size, each of the blocks corresponding to an amount of uncompressed data that is an integer multiple of an uncompressed unit size, and wherein for each block, when the block includes a compressed floating point number having an unencoded indicator, the exponent value corresponding to the compressed floating point number is included in the block, and fetching the exponent value corresponding to the compressed floating point number comprises fetching the exponent value corresponding to the compressed floating point number from within the block.

9. The method according to claim 8, wherein the compressed floating point numbers are included in a compressed tensor with the dictionary, and the method comprises generating a tensor from the compressed tensor.

10. The method according to claim 9, wherein each block further comprises a block compressed-uncompressed index indicating a position within the tensor of the floating point numbers corresponding to the block, and generating the tensor further comprises referencing the block compressed-uncompressed index; and/or
wherein for each block including at least one unencoded indicator, the block comprises an unencoded exponent offset indicating a position within the block of the exponent value corresponding to the unencoded indicator, and the method further comprises, for each block including at least one unencoded indicator, referencing the unencoded exponent offset for the block.

11. The method according to anyone of claims 9 to 10, wherein the compressed tensor comprises a tensor uncompressed-compressed index that associates portions of the tensor with respective positions within the compressed tensor, and the method further comprises referencing the tensor uncompressed-compressed index to identify (i) a block of the compressed tensor corresponding to a designated portion of the tensor, and (ii) a position within uncompressed data of the identified block corresponding to the floating point numbers of the designated portion of the tensor.

12. The method according to anyone of claims 9 to 11, wherein the compressed tensor comprises a tensor compressed-uncompressed index that associates, for each of the blocks, the respective position within the tensor of the floating point numbers corresponding to the block, and generating the tensor further comprises referencing the tensor compressed-uncompressed index.

13. A processing system comprising:
a processing chip having a processor and a direct memory access (DMA) and decompression engine; and
an external memory,
wherein the DMA and decompression engine is operable to receive multiple compressed floating point numbers and implement decompression of the compressed floating point numbers by
for each of the compressed floating point numbers that has been generated from a respective floating point number by substituting one of an exponent index or an unencoded indicator for an exponent value of the floating point number
when the compressed floating point number includes an exponent index, accessing a dictionary that associates exponent values with respective exponent indices to cross-reference the exponent index to the exponent value of the floating point number, and generating the floating point number from the compressed floating point number by substituting the exponent value of the floating point number for the exponent index; and
when the compressed floating point number includes an unencoded indicator, fetching the exponent value of the floating point number, and generating the floating point number from the compressed floating point number by substituting the exponent value of the floating point number for the unencoded indicator.

14. The processing system according to claim 13, wherein when the compressed floating point numbers are arranged into one or more blocks of equal size, each of the blocks corresponding to an amount of uncompressed data that is an integer multiple of an uncompressed unit size, and wherein for each block, when the block includes a compressed floating point number having an unencoded indicator, the exponent value corresponding to the compressed floating point number is included in the block and fetching the exponent value corresponding to the compressed floating point number comprises fetching the exponent value corresponding to the compressed floating point number from within the block.

15. The processing system according to claim 14, wherein the compressed floating point numbers are included in a compressed tensor with the dictionary, and the method comprises generating a tensor from the compressed tensor.
